Europäisches Patentamt

European Patent Office    (11) Publication number:    **0 232 949**

Office européen des brevets    **A2**

(19)

## (12) EUROPEAN PATENT APPLICATION

(21) Application number: 87200193.8

(51) Int. Cl.⁴: **G11C 15/00 , G06F 12/06**

(22) Date of filing: 09.02.87

(30) Priority: 12.02.86 NL 8600342

(43) Date of publication of application:
**19.08.87 Bulletin 87/34**

(84) Designated Contracting States:
**DE FR GB SE**

(71) Applicant: **N.V. Philips' Gloeilampenfabrieken
Groenewoudseweg 1
NL-5621 BA Eindhoven(NL)**

(72) Inventor: **Gubbels, Wilhelmus Christianus
Octrooibureau B.V. Prof. Holstlaan 6
NL-5656 AA Eindhoven(NL)**
Inventor: **Van Zanten, Adrianus
Octrooibureau B.V. Prof. Holstlaan 6
NL-5656 AA Eindhoven(NL)**

(74) Representative: **Strijland, Wilfred et al
INTERNATIONAAL OCTROOIBUREAU B.V.
Prof. Holstlaan 6
NL-5656 AA Eindhoven(NL)**

(54) **Word-organised, content-addressable memory.**

(57) A description is given of a word-organised, content-addressable memory. The information is stored in memory circuits, each comprising several word location sections of several information bits each. The memory circuits are arranged in several columns of one or more memory circuits each, or in several rows of one or more memory circuits each. If there are several columns, a handshake is maintained for each row via a first (M) line in order to globalise a search termination signal and a read termination signal, respectively, and via a second (C) line in order to transport a selection termination signal and to globalise a cut-off signal, respectively. If there are several rows, there is an equal number of control circuits with two tree structures provided in order, respectively, to form at an accelerated rate a signal "at least one word location shows correspondence" and a signal "at least two word locations show correspondence".

FIG. 2

FIG. 3

## Word-organised, content-addressable memory.

The present invention relates to a word-organised, content-addressable memory provided with a series of integrated remory circuits, which define word locations with corresponding word location sections comparable with masked keywords, and with a separate integrated control circuit for supplying a clock signal (PHI) to each memory circuit, in order to receive correspondence signals obtained from the memory circuits comprising the word location sections by comparison with masked keywords for each word location, and thereupon to supply selection signals to the above-mentioned memory circuits, which indicate the word locations, the content of which is subjected to operations determined by specific code signals, account being taken of a particular sequence of handling these operations in the event of correspondence signals being received from several word locations. Preferably, the transport of the correspondence signals and the selection signals relating to one word location takes place over one word line (MWL). A memory of this kind is known from the Dutch patent application no. 77.13949 and the U.S. patent no. 4,296,475, incorporated here by way of reference.

The memory circuits can be grouped in matrix chips (M chips), each consisting of, for example, 16 words of 16 bits, or 16 rows of 16 memory circuits. The M chips can then, in turn, be arranged in rows as well as in columns. In other words, the memory can be purely modular in construction. Similarly, the control circuit can be constructed as a module by designing it per M chip or per row of M chips as a control chip - (C chip). An equal number of C chips are then used for a number of rows of M chips. The exchange of correspondence signals and selection signals is preferably effected via a bidirectional control bus built up of as many word lines as there are words stored in an M chip or a row of M chips. This control bus connects an M chip or a row of M chips with a C chip. The exchange of correspondence signals and selection signals takes place under the control of clock signals and specific code signals. This exchange process take up more time in proportion as there are both more M chips in a row and more rows of M chips. The object of the invention is therefore to provide means to enable this exchange of correspondence signals and selection signals and the operations in the memory circuits and in the control circuit generated by these signals to take place as quickly as possible, in particular, with a modular design of the system. In order to achieve this objective various measures can be taken in accordance with the invention.

As a first measure in accordance with the invention provision is made for a word-organised, content-addressable memory, as described in the preamble, characterised in that a first signalling line (M line) is present, which is provided with means for forming local search termination signals in the relevant memory circuits after activation by the clock signal (PHI) and as soon as the above-mentioned correspondence signals have next been supplied to the control circuit, after which on the basis of these local search termination signals a general search termination signal is obtained which is supplied to the control circuit, in that a second signalling line (C line) is present, which is provided with means for supplying a selection termination signal from the control circuit to the relevant memory circuits after reception of the general search termination signal and as soon as the above-mentioned selection signals have next been supplied to the relevant memory circuits, in that the first signalling line (M line) is also provided with means for supplying a general read termination signal from the relevant memory circuits to the control circuit after reception of the selection termination signal by the memory circuits and as soon as the content of a word location indicated by the selection signals has been processed on the basis of specific code signals, in that the second signalling line (C line) is also provided with means for bringing it into the state in which a general cut-off signal from the relevant memory circuits restores the second signalling line to its original signal level after reception of the general read termination signal by the control circuit, after which the cycle started by the clock signal (PHI) is terminated.

Preferably, likewise in accordance with the invention, the means in the first and second signalling lines - (the M and C lines, respectively) constitute a first and second wired logic function, respectively, so that the general search termination signal obtained after the formation of the last-generated local search termination signal frees the second signalling line (C line) for the transport of a selection termination signal, and, after the content of the relevant memory circuits has thereupon been read out, which is indicated by local read termination signals, the general read termination signal obtained at the first formed local read termination signal frees the second signalling line (C line), after which, after the formation of the local read termination signals, corresponding local cut-off signals are obtained in the relevant memory circuits, with the general cut-off signal obtained after the last local cut-off signal being placed on the second signalling line.

As a further measure in accordance with the invention, provision is made for a word-organised, content-addressable memory, as described in the preamble, characterised in that the control circuit is provided with a first logic tree structure, to which input signals ($VM_i$ with $i = 1, 2, ..., n$) are supplied, which correspond to the correspondence signals obtained for each word location section from a group of n word location sections, and of which the output signal can be represented in Boolean form by

$$TM = \sum_{i=1}^{n} VM_i$$

and indicates that at least one of the word location sections from the group of n word location sections corresponds to the masked keyword supplied, and a second logic tree structure to which the same input signals are supplied as to the first logic tree structure, as well as an input signal (P), which indicates that at least one word location section preceding the group of n word location sections in the memory corresponds to the masked keyword supplied, and of which the output signal can be represented in Boolean form by

$$SM/MM = P \cdot \sum_{i=1}^{n} VM_i + \sum_{i,j=1}^{n} VM_i \cdot VM_j$$

$$(i \neq j)$$

and indicates that at least two word location sections from the total word location sections then investigated correspond to the masked keyword supplied.

By combining the input signals of these tree structures in groups and integrating them in the propagation line present in the control circuit, by means of which the successive selection signals in this are derived and, if several rows of M-chips are present, by again combining the tree structures in groups, a very rapid and efficient circuit is obtained. By providing each of the C-chips with a specific circuit, it is possible to form a tree structure between a long column of C-chips without a separate chip being needed for combining the signals emitted by the C-chips, but it is possible to make do with a wiring which interconnects the column of C-chips.

The invention will now be explained in detail on the basis of the accompanying drawings, in which:

figure 1 gives a general picture of a word-organised, content-addressable memory;

figure 2 shows a circuit, on the basis of which the exchange of the time control signals between the memory circuits and the control circuit will be explained;

figure 3 shows a number of diagrams to explain the operation of the circuit illustrated in figure 2;

figure 4 shows a part of the control circuit;

figure 5 shows an embodiment of the first tree structures;

figure 6 shows an embodiment of the second tree structure;

figure 7 shows the specific circuit for four C-chips with the external wiring which is needed for the realisation of a tree structure;

and

figure 8 shows schematically the combination of the specific circuits illustrated in figure 7 if a long column of C-chips is present;

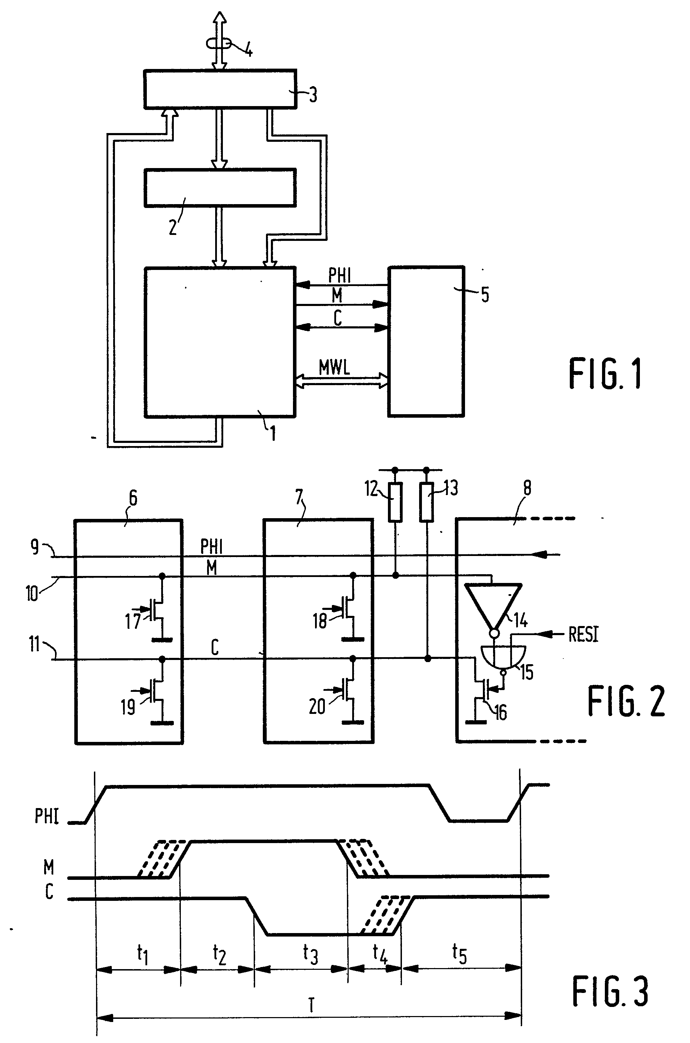

figure 1 shows a word-organised, content-addressable memory, built up from a series of integrated memory circuits 1, a mask register 2, an information multiplexer 3, a bidirectional information line 4 and a separate integrated control circuit 5. The memory circuits can be grouped in matrix chips (M-chips), each consisting of, for example, 16 words of 16 bits, or 16 rows of 16 memory circuits The M-chips can, in turn, be arranged both in rows and in columns. In other words, the memory can be purely modular in construction. The memory words stored in an M-chip or a row of M-chips can comprise a key field and a data field. The contents of the key field, or a part of it, are compared with the contents of a masked keyword which is stored in the mask register 2. If the information content of the non-masked bits of the keyword and of the corresponding bit positions of a stored word in the integrated memory circuits correspond, then a correspondence signal is given for the relevant word. These words can be read out or processed in some other way, depending on the code signals supplied for this purpose in coded form, in which respect account is taken of a particular sequence of handling these operations in the event of such correspondence signals being given for several words in the memory. Via the bidirectional information line 4

3

and the information multiplexer 3, information is supplied directly to the memory circuits 1 or, in so far as masked keywords are concerned, via the mask register 2, and in addition the information read out of the memory is supplied to a user's device. The way in which the memory circuits are constructed, as well as the organisation of the reading in and reading out of information, the masking of the keywords, and the comparison of the masked keywords with the contents of the memory followed by the generation of correspondence signals per bit is known from the above-mentioned Dutch patent application and need not be further described here.

From the above-mentioned Dutch patent application it is also known that the control circuit 5 which forms part of the word-organised, content-addressable memory, comprises facilities for registering for which word location sections a correspondence signal has been given and for changing these registered data if necessary, as well as facilities for indicating the word status, that is, facilities for indicating whether a word location contains valid information, and for changing the status of this word location if necessary, and indication facilities for indicating whether certain words in the memory circuits, particularly those for which correspondence signals have been given, have or have not yet been read out. The known memory circuit further comprises selection facilities for indicating, on the basis of the signals given by the indication facilities, the word locations of which the contents must be read out or processed in some other way, as well as -at least when the contents of several of such word locations must be read out or processed in some other way -the sequence in which these operations must take place. The selection signals emitted by the selection facilities for this purpose are supplied to the relevant memory circuits. All these facilities, in so far as they relate to an M chip or to a row of M chips, can be incorporated in a single C chip. As a result, the control circuit, as will be further explained later on, can also be modular in construction, particularly if several rows of M chips or a column of M chips is present. The transport of the correspondence signals from the memory circuits and of the selection signals from the control circuit preferably takes place via one single word line MWL which is present for each word location. The word lines together form a control bus; this control bus therefore connects an M chip or a row of M chips (if several M chips are needed to record a word in the memory) with a C chip. In the embodiment in question there are therefore 16 lines MWL1-16 for a row of M chips. In order to enable the exchange of correspondence signals and selection signals to take place as rapidly as possible, two signalling lines are available, namely an M line and a C line, in addition to a clock signal PHI.

Figure 2 shows the line 9 for the clock signal PHI and the M and C lines 10 and 11, respectively, for two M chips 6 and 7 and a C chip 8. The two signalling lines 10 and 11 both comprise a wired logic function, consisting of an open-drain output line with a resistor 12 and 13, respectively. It goes without saying that instead of a wired logic function other logic circuits can be used to obtain the same functional result. Via a logic circuit consisting of an inverter 14 and a NOR gate 15, and an FET 16 connected to the C line, the C line can be influenced by the logic level on the M line or by a signal RESI generated in the control circuit. This logic circuit 14, 15, with the FET 16, forms part of the control circuit 5. The operation of this circuit is explained on the basis of figure 3. The process of exchanging correspondence signals and selection signals and the operations partly generated by this in the memory circuits and control circuit take place in cycles with a possibly variable duration T, which is determined by the clock signal PHI emitted by a time control unit which forms part of the control circuit. At the start of each cycle the logic level of the M line is "0" and that of the C line is "1". The memory circuits are activated by the clock signal PHI, in the sense that the contents of each memory circuit of a word location section determined by a masking are compared with the contents of the corresponding bits of the corresponding masked keywords presented. As soon as this comparison process has been carried out for a particular word in the memory circuits, a local search termination signal is formed for each M chip from the row of M chips involved in this and is supplied to the gate of an FET present for this purpose in each M chip (in figure 2 the FETs 17 and 18). The moment at which the local search termination signals are formed in the relevant M chips varies as a result of tolerance differences in the switching speed of each chip. The local search termination signals bring the above-mentioned FETs connected to the M line (in figure 2, the FETs 17 and 18) into the blocked state. When the last-generated local search termination signal has been given, and therefore all the relevant FETs connected to the M line have been brought into the blocked state, the logic level of the M line changes; this change constitutes the general search termination signal. Figure 3 shows the local search termination signals for four M chips in a row in the form of dashed lines; the last-generated search termination signal, however, effects almost directly the transition from the logic level of the M line to "1" and is therefore indicated coinciding with the general search termination signal. While the general search termination signal is being obtained, the correspondence signals applying to the relevant word locations are delivered to the control circuit 5, which is thus activated. During the time $t_1$ (see figure 3) the M chips are therefore active; after this time has elapsed the C chip becomes active.

4

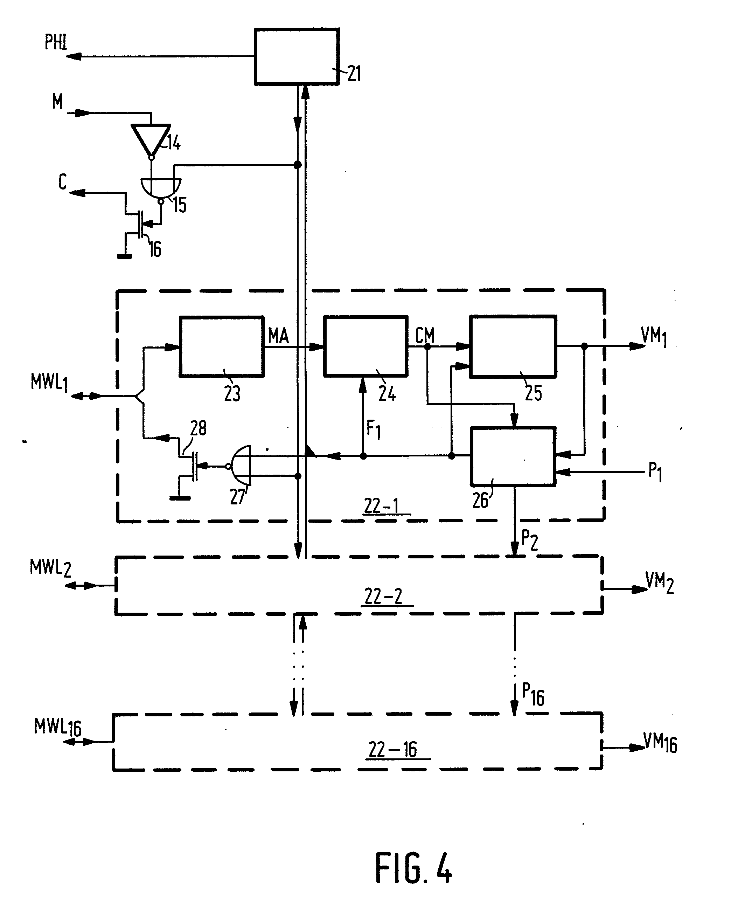

If the logic level of the M line goes to "1" after the time $t_1$ has elapsed, then the C line still remains at the logic level "1" for a time $t_2$. During this time, however, the C line is not compelled to adopt this logic value by the M line; the logic level of the C line will therefore change over to "0" as soon as the signal RESI is supplied, and as a result of this signal the FET 16 becomes conductive. When the C chip becomes active, the correspondence signals supplied via the relevant MWL lines for each word location are registered and from these, in the manner described, for example, in the above-mentioned Dutch patent application and as is briefly explained below on the basis of figure 4, the selection signals are derived which indicate the words in the memory circuits which must be read out or processed in some other way, as well as the sequence in which this must take place. This is achieved by maintaining the word line selected at a particular moment at the logic level "1" and bringing all the other word lines to the logic level "0". The moment at which the selection and determination of the sequence takes place is determined by the time control signal RESI, generated, as will be explained below, in the control circuit. As soon as the C line has been brought to the logic level "0" by the signal RESI, the M chips again become active and the M line takes over the control of the C line. The changeover of the logic level on the C line to "0" constitutes the selection termination signal.

Within the M chips the voltage at the gates of the FETs connected to the C line (in figure 2, the FETs 19 and 20) is brought to a value such that these FETs would be conductive if the logic level on the C line were "1". In fact, at that moment, as mentioned above, the logic level on the C line is "0".

As soon as the selection termination signal has been given, the selected word stored in the memory can be read out or processed in some other way. If correspondence signals have been given for several word locations, the corresponding words can then be read out in successive cycles. For this purpose the selection signals are given in a particular sequence. As soon as a word has been read out, local termination signals are formed in the relevant M chips which are supplied to the gates of the FETs connected to the M line (in figure 2, the FETs 17 and 18). As a result, these FETs change over to the conductive state. As soon as the relevant FET in the fastest switching M chip has changed over to the conductive state, that is, after the elapse of the time $t_3$ (see figure 3), the logic level on the M line changes to "0"; this change constitutes the general read termination signal. Figure 3 again shows the local read termination signals as dashed lines for four M chips in a row and the first-generated local read termination signal coinciding with the general read termination signal. The C line is freed by this general read termination signal, that is, the logic level on the C line is no longer determined by the logic level on the M line. The local read termination signals each effect the formation of a local cut-off signal in the relevant M chip; this means that the voltage at the gates of the FETs connected to the C line (in figure 2, the FETs 19 and 20) acquires a value such that these FETs are blocked. It is only when the relevant FET in the slowest-switching M chip is blocked that the logic circuit on the C line returns to its original value "1"; this transition constitutes the general cut-off signal. After that, the M line and the C line are at the same logic value as at the start of the cycle. The clock signal PHI stops and a new cycle can begin as soon as the next clock signal starts. Two control signals per cycle are therefore sent from the memory circuits to the control circuit via the M line, namely a general search termination signal and a general read termination signal, while a control signal is sent via the C line from the control circuit to the memory circuits, namely a selection termination signal. The general cut-off signal given via the memory circuits brings the C line back to its original state, but cannot be regarded as a control signal for the control circuit. The advantage of a minimum number of signalling lines is obtained by using the M and the C lines in this way.

Figure 4 shows a section of the control circuit 5 for an M chip or a row of M chips, 16 word lines MWL1-16. The circuit comprises a time control unit 21, the logic circuit 14, 15 and the FET 16, as well as a control circuit 22-1, ..., 22-16 for each word line. The operation of the logic circuit 14, 15 and the FET 16 has been explained above on the basis of figure 3. The operation of the control sub-circuits will be explained on the basis of the control sub-circuit 22-1; the construction and operation of the other sub-circuits are identical to this. The control sub-circuits are, in principle, already known from the Dutch patent application 77.13949.

The control sub-circuit 22-1 consists of a correspondence register unit 21, a word status register unit 24, a word read-out indication register unit 25, a word selection circuit 26, a NOR gate 27 and an FET 28. As will be explained below, the control circuit 5 in an embodiment in accordance with the invention further comprises two tree structures in which, preferably, the word selection circuits of the separate control sub-circuits are integrated. These tree structures are not shown in figure 4, however.

The correspondence signal of a relevant word location section in the memory circuits which is supplied to the control sub-circuit 22-1 via the word line MWL1, is stored in the correspondence register unit 23. This correspondence register unit 23 can consist of a few flip-flops and simple logic; this is not important for the present invention, however. The contents of the word corresponding to this can be read out on the

5

commands SRR or RN or be read in on the command WFP. With the aid of the command SRR the word is read out in those memory circuits from which the correspondence signal has been received and stored and which is to be read out first in the event of several correspondence signals being received, while furthermore the information stored in the word must be regarded as "valid" (which is stored in the word status register unit 24) and, of course, has not yet been read out (which is kept updated in the word read-out indication register unit 25). With the aid of the command RN the following words, for which correspondence signals have been given, can then be read out in subsequent cycles. If a correspondence signal has been given and stored for a word in the memory circuits (the output signal of the correspondence register unit 23 is then MA = 1), while this word is regarded as "invalid", then another word can be written at the relevant location in the memory circuits; this operation is carried out by means of the command WFP. If all the "valid" words for which a correspondence signal has been stored have to be erased, then the command CPM is supplied for this purpose; the status of all these words is then changed to "invalid".

The word status register unit 24 comprises a number of logic circuits and a register element that gives the signal V when the status of the corresponding word is "valid". The output signal of the word status register unit 24 can be represented in Boolean form by:

$CM = WFP. \overline{V} + MA. \overline{WFP} .V$, in which the register element is put at $V = 1$ by the signal WFP.F1 and reset to $V = 0$ by the signal CPM.CM; here F1 indicates that the relevant word has been selected and can be read out or processed in some other way. The signal F1 is the output signal of the word selection circuit 26 and also acts here as a set signal for the register element in the word status unit 24. If all the words are to be given the status "invalid", or if the output signal CM has already been given for a particular word, then in anticipation of the operation to which the relevant word is subjected in the memory circuits, this same signal can now be used to change the status to "invalid". $CM = 1$ for a "valid" word ($V = 1$), for which a correspondence signal has been stored ($MA = 1$) or for an "invalid" word ($V = 0$), to which a different content can then be given ($WFP = 1$).

The signal CM is supplied to the word read-out indication register unit 25 for keeping note of whether the words, for which $CM = 1$, have or have not already been read out or processed in some other way. This word read-out indication register unit comprises a number of logic circuits and a register element that emits the signal D when the corresponding word has been read out as far as the control circuit is concerned. The output signal of the word read-out indication register unit 25 can be represented in Boolean form by:

$VM_1 = CM . \overline{(\overline{D} + \overline{SRR + RN})}$, in which the register element is put at $D = 1$ by the signal F1.(SRR + RN) and reset to $D = 0$ by the signal $\overline{CM} + \overline{SRR + RN}$. In other words, if no read-out command is present for the relevant word ($SRR + RN = 0$), then $\overline{D} = 1$ and $VM_1 = CM$ in every case. If a read-out command is then given after that ($SRR + RN = 1$), then the signal CM remains unchanged and, with this, also the signal $VM_1$. As soon as the relevant word has been selected, however, and can be read out ($F1 = 1$), which means that the read-out command has been completed for the control circuit, then $D = 1$ and $VM_1 = 0$. The signal $VM = 1$ given by the word read-out indication register unit 25 therefore has almost the same meaning as the signal $CM = 1$, on the understanding that $VM_1$ becomes zero as soon as the corresponding word has been selected and the selection signal has been supplied to the relevant memory circuits.

Both the signal CM and the signal $VM_1$ are supplied to the word selection circuit 26. This circuit delivers an output signal $F1 = CM.WP + VM_1.P_1$. For the commands SRR, RN or WFP, for which $VM_1 = 1$, the signal F1 effects the blocking of the FET 28 via the NOR gate 27 and the logic level on the word line MWL1 becomes "1". Since a selection signal is then only supplied to the memory circuits thus indicated, the logic level of all the other word lines MWL-16 must be brought to "0"; this is ensured by a running signal $P_i$, which successively frees the word selection circuits 26 in the individual control sub-circuits, and does this in such a way that a sequence is obtained in the activation of the word lines. For the activation of the first word line $P_1 = 1$. If $F = 1$, as a result of which a selection signal can be sent over the word line MWL1, the signal $P_2$ for the activation of the second word line MWL2 in a following cycle is simultaneously brought to $P_2 = 1$ by the signal $VM_1 = 0$. If the signal F2 becomes equal to 1 in the control circuit 22-2 in the following cycle, as a result of which a selection signal can be sent via the word line MWL2, then the signal $VM_2$ can simultaneously bring the signal $P_3$ for the activation of the third word line MWL3 to $P_3 = 1$, and so on. In every case, $P_{i+1} = P_i . \overline{VM_i}$. If a command WP is given, which means that parallel words should be indicated in the memory circuits for a read-in operation, then the logic level of all word lines must be kept at "1", at least for those words for which $CM = 1$. In the control circuit all the relevant signals then become $Fi = 1$. If no commands are to be carried out, then all the Fi will always remain zero and the logic

6

level on the relevant word lines remains "0". .The signals Fi are further only supplied to the time control unit 21, which derives from these signals the signal RESI already mentioned; the signal RESI has the same function for the accessibility of the word lines as in the case of the M and C lines in order to permit the transport of the signals via the word lines in the form of changes in the logic level.

The word selection circuit 26 in the control sub-circuits, as already mentioned, is integrated in two logic tree structures. The signals $VM_{1-16}$ are supplied to a first logic tree structure; the output signal of this tree structure can be represented in Boolean form by:

$$TM = \sum_{i=1}^{16} VM_i .$$

This signal TM indicates that a correspondence signal has been given for at least one of the 16 words in the M chip or in the row of M chips. As long as in successive cycles all the selection signals have not yet been generated in order to indicate the words for which a correspondence signal has been given, in the fixed sequence, the signal TM remains equal to 1. The signal TM is used to derive mode signals in an external processor; commands, particularly RN commands, can continue to be given until TM = 0.

Apart from the signals $VM_{1-16}$, the signal $P_1$ is also supplied to a second logic tree structure; if only one M chip or one row of M chips is used, then the signal $P_1$ is set permanently to the value "1". The significance of the signal $P_1$ for the second tree structure only becomes apparent when several rows of M chips are used and hence a column of C chips. The signal $P_1$, as already mentioned, also acts as a propagation signal for freeing the successive word selection circuits in the control sub-circuits. The output signal of the second logic tree structure is represented in Boolean form by:

$$SM/MM = P_1 . \sum_{i=1}^{16} VM_i + \sum_{i,j=1}^{16}$$

$$VM_i . VM_j (i \neq j)$$

and indicates that a correspondence signal has been given for at least two of the 16 words in the M chip or in the row of M chips, or, if a column of C chips is present, that a correspondence signal has been given for at least one of the 16 words in the last-investigated M chip or row of M chips, and that a correspondence signal has also been given for at least one of the words in a preceding M chip or row of M chips. For a column of C chips, the NOR function should be taken from the signals SM/MM obtained for each C chip. This NOR function can be achieved by supplying each of these SM/MM signals obtained for each C chip to an appropriate FET belonging to the second tree structure, in which respect the sources of these FETs are interconnected, so that here again a wired logic function is created. The signal SM/MM' emitted by this wired logic function and indicating the SM/MM signal for the entire column of control circuits is also supplied to an external processor and serves to keep note of whether several words in the memory are to be read out or processed in some other way.

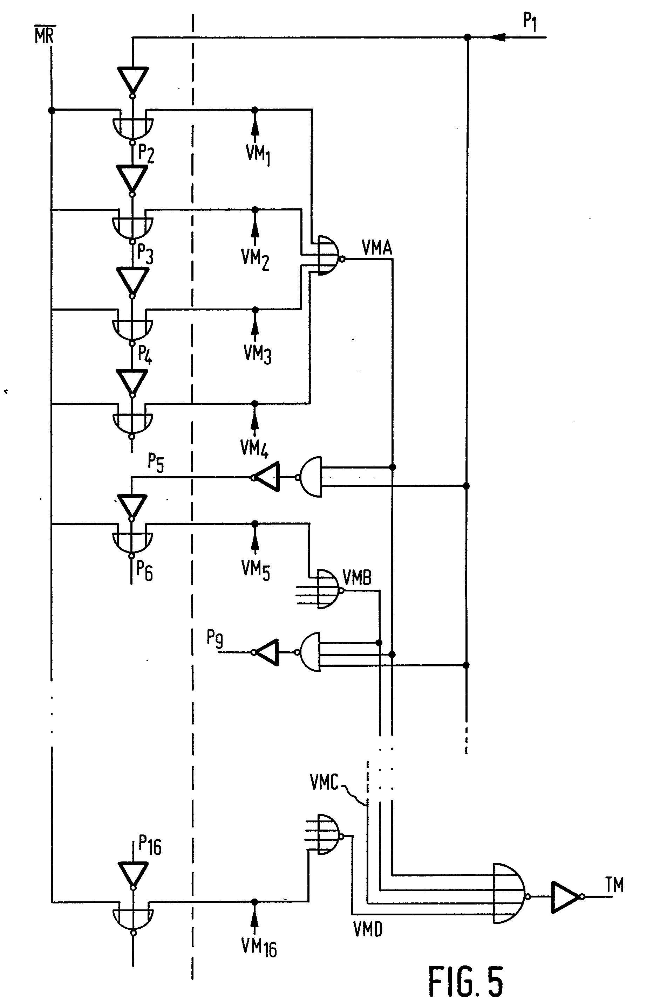

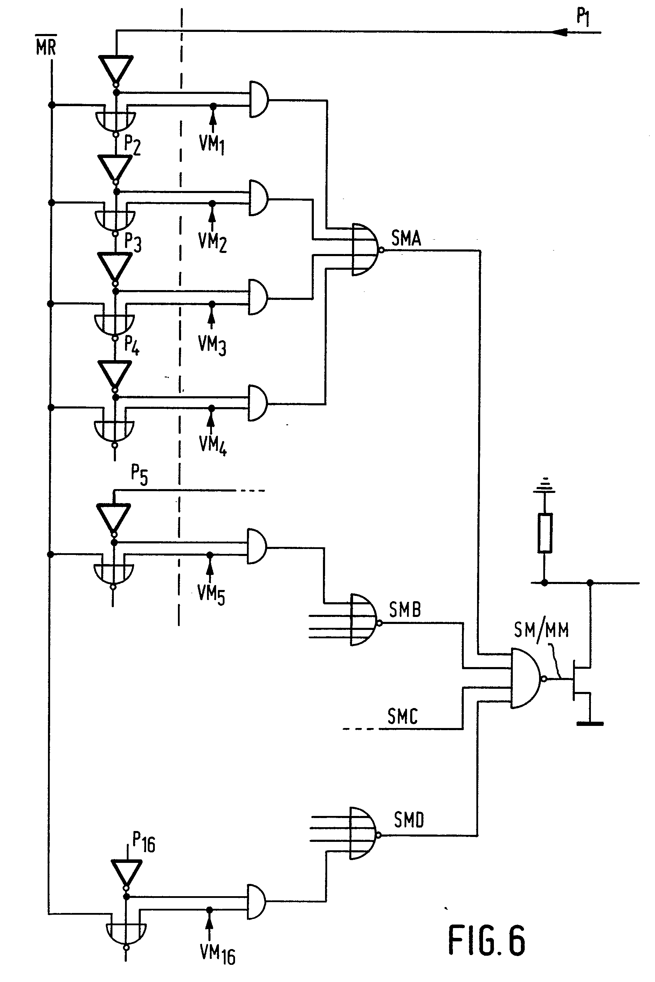

The propagation line formed by logic circuits in the word selection circuits, by means of which the signal $P_{i+1} = Pi . \overline{VM_i}$ is obtained, is integrated in both tree structures. An example of an embodiment of these tree structures with the propagation line is shown in figures 5 and 6.

The first tree structure is shown in figure 5; to the left of the vertical dashed line the parts which form the propagation line incorporated in the word selection circuits. An inverter and a NOR gate are present in the tree structure for each word selection circuit. The output of the NOR gates is always $P_{i+1} = Pi . \overline{VM_i}$ . MR. The propagation line for $P_i$ is therefore still keyed by a signal MR coming from the time control unit in order to be able to free the propagation line in the correct time interval. Apart from the signal MR, the signal $P_i$ can propagate itself completely in series according to the relation $P_{i+1} = P_i . \overline{VM_i}$ . Time is, however, gained by deriving the signal $P_5$, as well as the signals $P_9$ and $P_{13}$, directly from groups of four signals $VM_i$ and $P_i$. For this purpose, in the embodiment in question a further NOR gate is present for each group of four signals $VM_i$, which emits signals VMA, VMB, VMC and VMD, respectively. On the one hand, these four signals are combined by a last NOR gate and an inverter into the signal VM, which then satisfies the transfer function represented for this purpose in Boolean form and, on the other hand, are used to derive via a NAND gate and an inverter the signals $P_5$, $P_9$ and $P_{13}$, respectively, which signals are supplied directly to the input of a relevant section of the propagation line.

A second tree structure is shown in figure 6; as far as its structure is concerned this strongly resembles the first tree structure. The section to the left of the vertical dashed line is formed by the same part of the first tree structure, to the left of the vertical dashed line in figure 5. Here, too, the signal SM/MM ultimately to be obtained is derived via an intermediate step, in which the signals SMA, SMB, SMC and SMD are obtained first. The output signal SM/MM completely satisfies the above-mentioned transfer function represented in Boolean form.

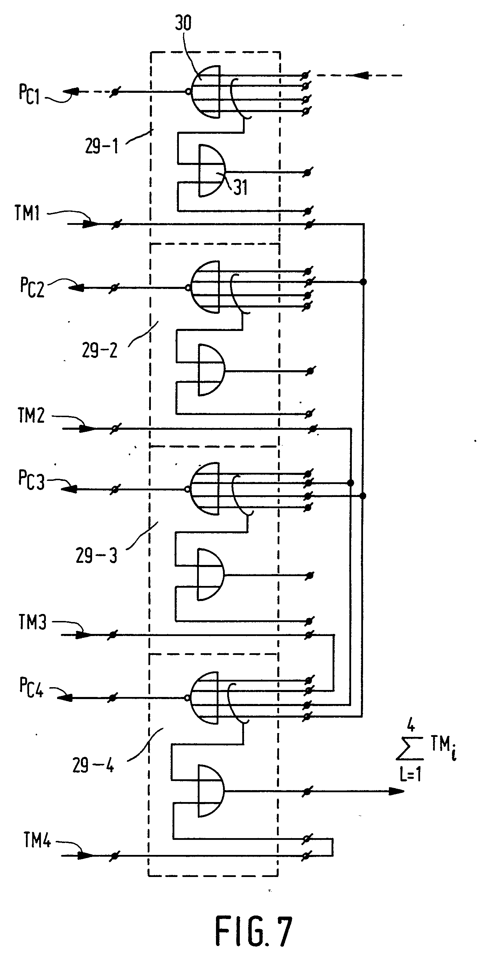

If several rows of M chips are present, and therefore a column of C chips, the first tree structures should be combined on the various C chips. It now proves possible to apply a permanent combination circuit formed by a NOR gate and an OR gate on each C chip, to combine the signals $TM_i$ from the first tree structure present for each C chip merely by introducing external wiring between the C chips and to do this for an arbitrarily long column of C chips and again in accordance with a tree structure. This combination possibility will now be first described for a group of four C chips. In figure 7 the permanent combination circuit, which is applied to the C chips C1, C2, C3 and C4, is indicated by 29-1, 29-2, 29-3 and 29-4; each combination circuit comprises an NOR gate 30 with four inputs and an OR gate 31, also with four inputs, three of which are the same as those of the NOR gate 30. In addition, a conductor is present for the supply and removal of the signal $TM_i$. By connecting the conductors present for this purpose in the combination circuits externally with the OR gate of the chip C4, the $TM_{1-4}$ obtained on the C chips C1-C4 in each tree structure result in a signal

$$\sum_{i=1}^{4} TM_i .$$

The first tree structure of the chip C1 is supplied with a fixed defined value $P_1$; the values $P_i$ for the chips C2, C3 and C4, namely $P_{C2}$, $P_{C3}$ and $P_{C4}$, are obtained from the NOR gates on the combination circuits 29-2, 29-3 and 29-4; here $P_{C2} = \overline{TM_1}$ , $P_{C3} = \overline{TM_1} . \overline{TM_2}$ and $P_{C4} = \overline{TM_1} . \overline{TM_2} . \overline{TM_3}$ .

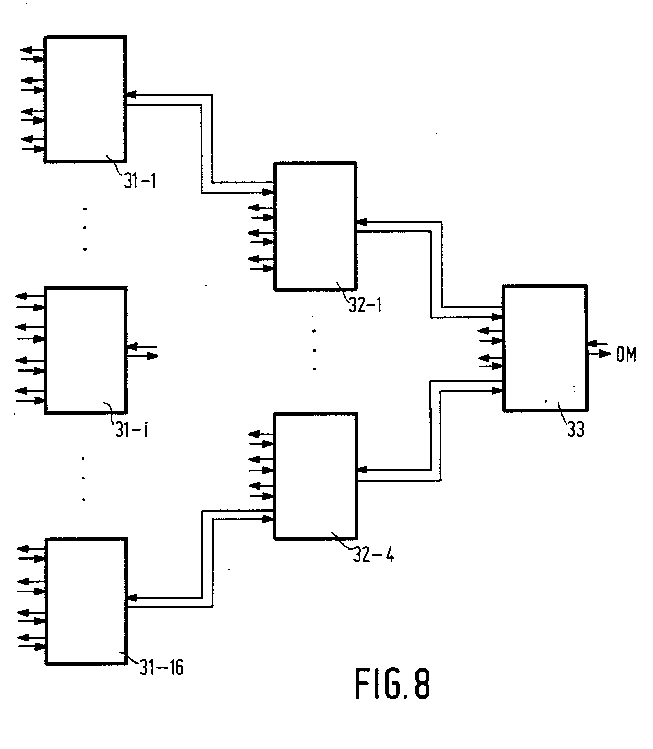

The NOR gate and the OR gate on the first combination circuit are therefore not used for the combination of the signals $TM_i$ for four C chips. These can, however, be used if the signals $TM_i$ are combined for several groups of four C chips. Such a situation is shown in figure 8.

Figure 8 is based on 64 C chips C1, C2, ... C64, which are combined at a first level into 16 groups of four C chips each time in a manner as explained above on the basis of figure 7. The groups are indicated by 31-1, 31-2, ..., 31-16. There are therefore 64 combination circuits 29-1, 29-2, ..., 29-64 which give 16 output signals:

$$\sum_{i=1}^{4} TM_i , \sum_{i=5}^{8} TM_i , \dots ,$$

$$\sum_{i=61}^{64} TM_i .$$

These signals are supplied to four groups of four, i.e. 16 combination circuits, at a second level, namely 32-1, 32-2, 32-3 and 32-4. The output signals of these four groups of four combination circuits are:

$$\sum_{i=1}^{16} TM_i , \sum_{i=17}^{32} TM_i ,$$

$$\sum_{i=33}^{48} TM_i \text{ and } \sum_{i=49}^{64} TM_i .$$

These four signals are supplied, in turn, to one group of four combination circuits, namely the circuit 33. The output signal of the circuit 33 is then

$$OM = \sum_{i=1}^{64} TM_i .$$

A value $P_1$ must be supplied to the propagation line on each C chip. For each group of four C chips only the value $P_1$ ($= P_{C1}$ in figure 7) need be supplied for the first C chip from a group of four. As can be seen from figure 7, the values $P_1$ ($= P_{C2}$, $P_{C3}$ and $P_{C4}$ in figure 7) for the propagation lines on the other C chips from a group of four are generated in the group of four combination circuits on the relevant four C chips. The value $P_1$ for the propagation line on the very first C chip in figure 8 is, in principle, supplied via the NOR gates of the first combination circuit of the groups 33, 32-1 and 31-1; since this value of $P_1$ is fixed this can be more easily supplied directly to the propagation line on the very first C chip. Since for each group of four C chips the value of $P_1$ for the propagation line on the first C chip of a group of four is formed by the Boolean product of the inverted $TM_i$ values of the propagation lines on the C chips located before it, this value of $P_1$ is obtained from the combination of the $TM_i$ values of these C chips. Thus, for example, the circuit 32-1 gives the values

$$\prod_{i=1}^{4} \overline{TM_i}, \quad \prod_{i=1}^{8} \overline{TM_i} \text{ and}$$

$$\prod_{i=1}^{12} \overline{TM_i} \text{ to the circuits } 31-2, \; 31-3 \text{ and}$$

31-4 and the circuit 33 gives the values $\prod_{i=1}^{16} \overline{TM_i},$

$$\prod_{i=1}^{32} \overline{TM_i} \text{ and } \prod_{i=1}^{48} \overline{TM_i}$$

to the circuits-2, 32-3 and 32-4.

From the above it can be seen that not all the logic elements of the combination circuits are used. The combination circuits are designed in such a way that the circuits 32-1, 32-2, 32-3, 32-4 and 33 can be constructed entirely of the unused elements on the combination circuits of the first level. Of the NOR gates on the combination circuits, only the NOR gates of the last three of each group of four combination circuits are used; the first is therefore still available. Of the OR gates on the combination circuits only the OR gate of the last of each group of four combination circuits is used; the others are therefore still available.

As regards level 2, the second, third and fourth NOR gates of the circuits 32-1, 32-2, 32-3 and·32-4 are replaced by the NOR gates of the combination circuits on the C chips 5, 9, 13; 21, 25, 29; 37, 41, 45 and 53, 57, 61. At level 3 the second, third and fourth NOR gates of the circuit 33 are replaced by the NOR gate of the combination circuits on the C chips 17, 33 and 49. Furthermore, for level 2 the fourth OR gate of the circuits 32-1, 32-2, 32-3 and 32-4 is replaced by the OR gate of the combination circuits on the C chips 13, 29, 45 and 61. At level 3 the fourth OR gate of the circuit 33 is replaced by the OR gate of the combination circuit on the C chip 49.

Generally speaking, the n[th] NOR gate of a group of four combination circuits can be replaced at the level M by the NOR gate of the combination circuit on the C chip with the rank number $(n -1 + 4K) \cdot 4^{M-1} + 1$, in which n = 2, 3, 4, and M = 1, 2, ... while k = 0, 1, ... and indicates the number of the group of four combination circuits within a particular level of which the NOR gates must be replaced. Generally speaking, it is also true that each fourth OR gate of a group of four combination circuits can be replaced at the level M by the OR gate of the combination circuit on the C chip with the rank number $(3 + 4k) \cdot 4^{M-1} + 1$, in which M = 1, 2, ... while k = 0, 1, and indicates the number of the group of four combination circuits within a particular level of which the OR gate must be replaced.

In this way, a completely finished tree structure can be obtained in a column of a basically unlimited number of C chips; all that is required for this is an external wiring of the C chips. The significance of the OM signal then obtained is, in principle, the same as that of TM when one single C chip is used.

In the example of an embodiment given here the tree structure comprises five levels, of which only two are, however, realised on a C chip for each first tree structure and three by the external wiring of the 64 C chips.

In order to determine the time gained by using this tree structure it is necessary to start from the worst-case situation, in which the first correspondence signal is obtained for the last word in the memory. To obtain the signal $TM_i$ two levels are gone through on the first tree structure; to obtain the signal OM another three levels are gone through via the external wiring of the 64 C chips. This therefore represents a total of five levels. The necessary signal P, however, also has to go through four levels, but in the reverse direction. The total delay in the tree structure is therefore nine unit delays per level.

If $4^n$ words can be stored in the memory, then the number of levels that must be gone through to obtain the signal OM is equal to n; the signal P goes through another n-1 levels so that the total delay amounts to 2n-1 unit delays. In a complete series version of the propagation line the delay is $4^n$. The speed of the propagation line with the tree structure used is therefore considerably greater.

## Claims

1. Word-organised, content-addressable memory provided with a series of integrated memory circuits, which define word locations with corresponding word location sections comparable with masked keywords, and with a separate integrated control circuit for supplying a clock signal (PHI) to each memory circuit, in order to receive correspondence signals obtained from the memory circuits comprising the word location sections by comparison with masked keywords for each word location, and thereupon to supply selection signals to the above-mentioned memory circuits, which indicate the word locations, the content of which is subjected to operations determined by specific code signals, account being taken of a particular sequence of handling these operations in the event of correspondence signals being received from several word locations, characterised in that a first signalling line (M line) is present, which is provided with means for forming local search termination signals in the relevant memory circuits after activation by the clock signal - (PHI) and as soon as the above-mentioned correspondence signals have next been supplied to the control circuit, after which on the basis of these local search termination signals a general search termination signal is obtained which is supplied to the control circuit, in that a second signalling line (C line) is present, which is provided with means for supplying a selection termination signal from the control circuit to the relevant memory circuits after reception of the general search termination signal and as soon as the above-mentioned selection signals have next been supplied to the relevant memory circuits, in that the first signalling line (M line) is also provided with means for supplying a general read termination signal from the relevant memory circuits to the control circuit after reception of the selection termination signal by the memory circuits and as soon as the content of a word location indicated by the selection signals has been processed on the basis of specific code signals, in that the second signalling line (C line) is also provided with means for bringing it into the state in which a general cut-off signal from the relevant memory circuits restores the second signalling line to its original signal level after reception of the general read termination signal by the control circuit, after which the cycle started by the clock signal (PHI) is terminated.

2. Word-organised content-addressable memory according to Claim 1, characterised in that the means in the first and second signalling lines (the M and C lines, respectively) constitute a first and second wired logic function, respectively, so that the general search termination signal obtained after the formation of the last-generated local search termination signal frees the second signalling line (C line) for the transport of a selection termination signal, and, after the content of the relevant memory circuits has thereupon been read out, which is indicated by local read-termination signals, a general redetermination signal obtained at the first formed local read-termination signal freeze the second signalling line (C line), after which, after the formation of the local read-determination signals, corresponding local cut-off signals are obtained in the relevant remory circuits with the general cut-off of signal obtained after the last local cut-off signal being placed on the second signalling line.

3. Word-organised, content-addressable memory provided with a series of integrated memory circuits, which define word locations with corresponding word location circuits comparable with masked keywords, and with a separate integrated control circuit for supplying a clock signal (PHI) to each memory circuit, in order to receive correspondence signals obtained from the memory circuits comprising the word location sections by comparison with masked keywords for each word location, and thereupon to supply selection signals to the above-mentioned memory circuits, which indicate the word locations, the content of which is subjected to operations determined by specific code signals, account being taken of a particular sequence of handling these operations in the event of correspondence signals being received from several word locations, characterised in that the control circuit is provided with a first logic tree structure, to which input

signals ($VM_i$ with $i = 1, 2, ..., n$) are supplied, which correspond to the correspondence signals obtained for each word location section from a group of n word location sections, and of which the output signal can be represented in Boolean form by

$$TM = \sum_{i=1}^{n} VM_i$$

and indicates that at least one of the word location sections from the group of n word location sections corresponds to the masked keyword supplied, and a second logic tree structure to which the same input signals are supplied as to the first logic tree structure, as well an input signal (P), which indicates that at least one word location section preceding the group of n word location sections in the memory corresponds to the masked keyword supplied, and of which the output signal can be represented in Boolean form by

$$SM/MM = P.\sum_{i=1}^{n} VM_i + \sum_{i,j=1}^{n} VM_i . VM_j$$

$$(i \neq j)$$

and indicates that at least two word location sections from the total word location sections then investigated correspond to the masked keyword supplied.

4. Word-organised, content-addressable memory in accordance with claim 3, characterised in that the successive input signals $VM_i$ are taken together in groups and supplied to first gate circuits, after which the output signals of these first gate circuits are taken together in groups and supplied to second gate circuits and so on until the top of the first logic tree structure is reached and the signal TM is obtained, in that furthermore each of the output signals of the first gate circuits is taken together with the said input signal P and supplied to third gate circuits, after which the output signals of these third gate circuits act as an input signal for a propagation line divided into sections for the successive activation of the word selection circuits in the control circuit generating the selection signals, which sections as regards their length correspond to the group-wise division of the input signals $VM_i$.

5. Word-organised, content-addressable memory in accordance with claim 4, characterised in that each of the successive input signals $VM_i$ is taken together with a corresponding signal $P_i$ generated in the propagation line determined by the input signal $VM_{i-1}$ and a signal $P_{i-1}$ previously generated in the progagation line and is supplied to fourth gate circuits, the output signals of which are taken together in groups and supplied to fifth gate circuits, after which the output signals of these fifth gate circuits are again taken together in groups and supplied to sixth gate circuits and so on until the top of the second logic tree structure is reached and the signal SM/MM is obtained.

6. Word-organised, content-addressable memory comprising several rows of word-organised memories and a column of control circuits operating together with these in accordance with one of the claims 3-5, characterised in that each control circuit is provided with a combination circuit, in which respect k combination circuits each time are combined into a group with the aid of which from the signals $TM_{m+1}$, $T_{m+2}, ..., TM_{m+k}$ the signal

$$\sum_{i=m+1}^{m+k} TM_i$$

is derived, which is taken together with k-1 corresponding output signals obtained from other identical groups of k combination circuits and supplied to new identical groups of k combination circuits, after which the output signals of these new groups are likewise taken together and supplied to further groups of k combination circuits and so on until the top of the tree structure then obtained is reached and a signal

$$OM \sum_{i=1}^{s} TM_i$$

is obtained, in which respect s is the number of control circuits in a column, in that furthermore going back from the top of the tree structure starting from an initial value of P the corresponding P signals for the preceding groups located in the tree structure are given each time, and this continuing until the starting signals P, for the logic tree structures present for each control circuit are given, in which respect each of the P signals can be represented by

$$P_{r+1} = \prod_{i=1}^{\frac{r}{4}} \overline{TM_i},$$

with r being the rank number of a relevant control circuit.

7. Word-organised, content-addressable memory in accordance with claim 6, characterised in that each combination circuit comprises a first gate circuit for giving signals in the direction of the top of the tree structure and a second gate circuit for giving signals in the direction of the base of the tree structure, in that groups of four combination circuits are formed each time, in which respect for the first gate circuit of the fourth combination circuit of a group at a level M in the tree structure the first gate circuit is taken of the combination circuit in the control circuit with the rank number $(3 + 4k) \cdot 4^{M-1} + 1$, with M = 1, 2, ..., while k = 0, 1, ... indicates the rank number of the group of four combination circuits within a particular level, in which respect furthermore the second gate circuit of the combination circuit in the control circuit with the rank number $(n -1 + 4K) \cdot 4^{M-1} + 1$ is taken from the $n^{th}$ (n = 2, 3 or 4) combination circuit of a group at a level M in the tree structure for the second gate circuit.

8. Word-organised, content-addressable memory in accordance with claim 6, characterised in that a wired NOR function is present, by means of which an SM/MM' signal valid for the whole system is obtained from the output signals of the two tree structures (SM/MM) obtained for each control circuit.

FIG.1

FIG.2

FIG.3

FIG. 4

FIG. 5

FIG.6

FIG. 7

FIG.8